# FASCICULE DE BREVET EUROPEEN

(11) **EP 0 402 189 B1**
(45) Date de publication et mention de la délivrance du brevet: **10.11.1993**
(21) Numéro de dépôt: 90401284.6
(22) Date de dépôt: 15.05.1990
(51) Int. Cl.: H01S 3/19, H01L 33/00

(54) **Dispositif optoélectronique sur substrat semi-isolant**
Optoelektronische Anordnung auf halbisolierendem Substrat
Optoelectronic device on a semi-insulating substrate

(30) Priorité: 06.06.1989 FR 8907454
(43) Date de publication de la demande: 12.12.1990
(73) Titulaire: THOMSON-CSF, 75008 Paris (FR)
(72) Inventeur: Blondeau, Robert, F-92045 Paris la Défense (FR); Rondi, Daniel, F-92045 Paris la Défense (FR); Glastre, Geneviève, F-92045 Paris la Défense (FR); Krakowski, Michel, F-92045 Paris la Défense (FR)
(74) Mandataire: Ruellan-Lemonnier, Brigitte

(56) Documents cités:
- US-A- 4 365 336
- PATENT ABSTRACTS OF JAPAN, vol. 12, no. 239 (E-630)[3086], 7 juillet 1988 & JP-A-63-31187
- PATENT ABSTRACTS OF JAPAN, vol. 13, no. 181 (E-750)[3529], 27 avril 1989 & JP-A-1-7584
- ELECTRONICS LETTERS, vol. 17, no. 1, 8 janvier 1981, pages 12-14, Herts, GB; T. MATSUOKA et al.: "1.5 mum region InP/GaInAsP buried heterostructure lasers on semi-insulating substrates"

## Description

La présente invention concerne un dispositif optoélectronique sur substrat semi-isolant. Un tel dispositif est connu du document JP-A-63-31187.

Il existe actuellement un intérêt croissant pour les transmissions sur fibres optiques de signaux de très hautes fréquences tels que des signaux "radar". Aussi observe-t-on une forte demande pour la mise au point de dispositifs optoélectroniques permettant d'atteindre la bande X (8 - 12 GHz) ou la bande K_{U}(12-18 GHz). Actuellement, des lasers du type à ruban enterré permettent d'atteindre les 10 GHz. De tels lasers sont constitués, par exemple, par un ruban en matériau actif prévu entre deux couches de confinement inférieure et supérieure, chacune d'un type de conductivité différent, l'ensemble étant réalisé sur un substrat semi-conducteur. En fait, la limitation en fréquence de ces lasers provient essentiellement des éléments parasites situés de part et d'autre du ruban actif, en particulier des capacités parasites dues à l'homojonction P-N formée par le recouvrement des deux couches de confinement se trouvant de part et d'autre du ruban actif.

La présente invention a donc pour but de diminuer notablement cette capacité en proposant une nouvelle structure de dispositif optoélectronique réalisé sur un substrat semi-isolant.

Ainsi, la présente invention a pour objet un dispositif optoélectronique sur substrat semi-isolant du type comportant, empilés l'un sur l'autre, au moins :
- un substrat en matériau semi-isolant,
- une couche de confinement inférieure d'un premier type de conductivité,
- au moins une couche active sous forme de ruban,
- une couche de confinement supérieure d'un deuxième type de conductivité,

caractérisé en ce que la couche de confinement inférieure recouvre un côté du substrat semi-isolant en passant sous la couche active et en s'arrêtant au droit de cette couche active et en ce que la couche de confinement supérieure recouvre l'autre côté du substrat semi-isolant en passant sur la couche active et en s'arrêtant presque sensiblement au droit de cette couche active en laissant une surface d'homojonction P-N la plus faible possible.

Dans ce type de dispositif, on sépare physiquement la couche de confinement de type N et celle de type P, de part et d'autre du ruban actif. En conséquence, on diminue notablement la surface de l'homojonction P-N formée par le recouvrement des deux couches et constituant un des éléments parasites prépondérant limitant la fréquence du dispositif optoélectronique.

Selon un mode de réalisation permettant de bien contrôler la structure du ruban actif et des couches de confinement, la couche de confinement inférieure est constituée par la superposition d'une première couche d'arrêt d'attaque chimique, d'une couche de confinement proprement dite, d'une seconde couche d'arrêt d'attaque chimique et d'une couche en un matériau identique à celui de la couche de confinement.

D'autres caractéristiques et avantages de la présente invention apparaîtront à la lecture de la description de divers modes de réalisation, non limitatifs, faite ci-après avec référence aux dessins ci-annexés, dans lesquels :
- les figures 1A à 1G représentent les différentes étapes de réalisation d'un dispositif optoélectronique selon un premier mode de réalisation conforme à la présente invention ;
- la figure 2 est une vue en perspective d'un dispositif optoélectronique ci-dessus ;
- la figure 3 est une vue en perspective d'un dispositif optoélectronique conforme à la présente invention.

Pour simplifier la description dans certaines des figures, les mêmes références désignent les mêmes élements. D'autre part, la présente invention sera décrite en se référant plus particulièrement à des lasers à ruban enterré comme type de dispositif optoélectronique conforme à la présente invention. Toutefois, il est évident pour l'homme de l'art que la présente invention peut s'appliquer à tout dispositif optoélectronique comprenant une couche active empilée entre deux couches de confinement formant une homojonction N-P.

De plus, la présente invention sera décrite en se référant à un substrat semi/isolant en phosphure d'indium (InP) et à des matériaux semi-conducteurs tels que les matériaux InP GaInAsP ou GaInAs. Toutefois, il est évident que la présente invention peut s'appliquer à d'autres familles de matériaux semiconducteurs, en particulier les composés III et V de la classification périodique des éléments et leurs solutions solides, tels que GaAlAs, GaInAlAs, GaInAlSb, et...

De même, dans la description le ruban actif est constitué d'une seule couche. Toutefois, il est évident pour l'homme de l'art que le ruban actif peut être constitué de plusieurs sous-couches présentant des "gaps" différents de manière à former une structure à puits quantiques ou bien peut être constitué d'une couche active revêtue d'une couche de guidage réalisée sous forme d'un réseau distribué pour obtenir un laser DFB (distributed feedback en langue anglaise).

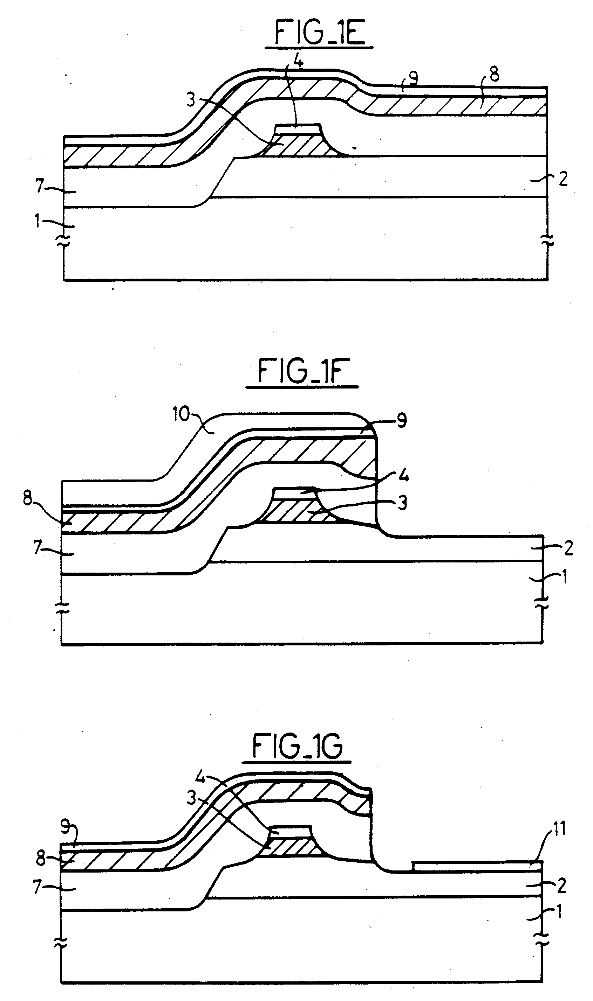

On décrira maintenant avec référence aux figures 1A à 1G, un premier procédé de réalisation d'un laser à ruban enterré sur substrat semi-isolant conforme à la présente invention. Comme représenté sur la figure 1A, on a réalisé sur un substrat semi-isolant 1 en phosphure d'indium (InP) dopé avec des impuretés telles que le fer) le cobalt ou similaire, une première épitaxie constituée d'une couche de confinement inférieure 2 réalisée en phosphure d'indium de type N, une couche active 3 en un matériau semiconducteur choisi parmi les composés ternaires ou quaternaires des groupes III et V de classification périodique des éléments et une couche de confinement supérieure 4 réalisée en phosphure d'indium de type P. L'épitaxie a été réalisée de manière connue en utilisant soit un procédé d'épitaxie organométallique en phase vapeur ou MOCVD (pour Métallo Organic Chemical Vapor Deposition) ou par un procédé d'épitaxie par jet moléculaire (MBE). D'autre part, il est évident pour l'homme de l'art que le dispositif optoélectronique peut aussi être réalisé avec une couche de confinement inférieure de type P et une couche de confinement supérieure de type N.

Comme représenté sur la figure 1B, après avoir déposé un ruban de résine 5 sur la partie à protéger, on réalise la gravure de la couche de confinement supérieure 4 et de la couche active 3 de manière à obtenir un ruban actif de largeur W. Cette gravure est réalisée sur une profondeur qui correspond sensiblement à l'épaisseur de la couche 4 et de la couche 3. La gravure utilisée est une gravure chimique de type connu.

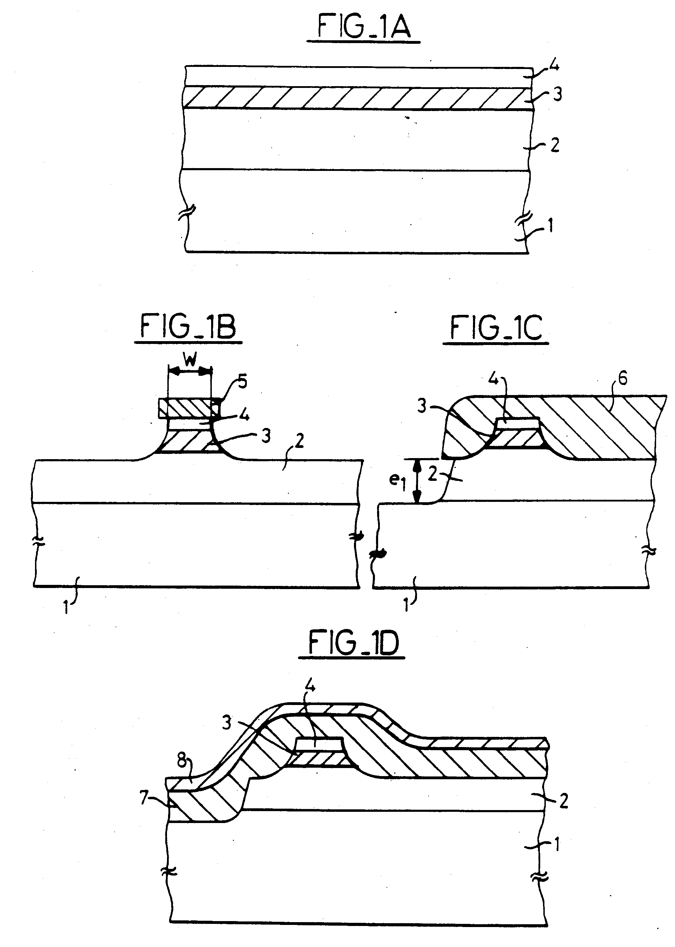

Comme représenté sur la figure 1C, après avoir recouvert la moitié du substrat et le ruban formé des couches 3 et 4 d'une couche de résine 6, on réalise une seconde gravure. Cette gravure est réalisée sur le côté gauche du substrat dans le mode de réalisation représenté, au droit du ruban constitué des couches 4 et 3. Cette gravure attaque principalement la couche de confinement inférieure 2 et elle est réalisée sur une épaisseur e1 correspondant sensiblement à l'épaisseur de la couche de confinement inférieure 2 de manière à mettre à nu le substrat 1. Ensuite, comme représenté sur la figure 1D, on réalise par épitaxie sur toute la largeur du dispositif, le dépôt d'une couche 7 en phosphure d'indium de type P, c'est-à-dire en même matériau que la couche de confinement supérieure 4. Sur cette couche 7, on dépose une couche de contact 8 réalisée en un composé ternaire de type P+ tel que du GaInAs. Sur cette couche 8, on dépose une couche métallique 9 constituée par exemple d'une double couche de platine et d'or, comme représenté sur la figure 1E.

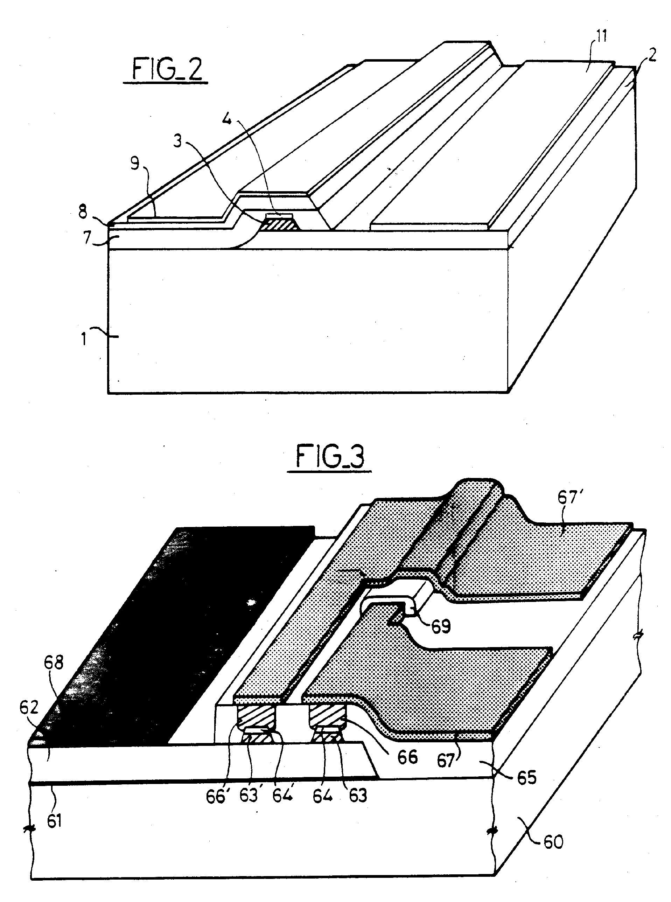

Ensuite, comme représenté sur la figue 1F, on dépose sur le premier côté du substrat, à savoir sur le côté gauche dans le mode de réalisation représenté, une couche de résine 10 qui s'étend de manière à recouvrir le ruban actif formé de la couche 3 et à s'arrêter sensiblement au droit de ce ruban actif. Ensuite, en utilisant tout d'abord un usinage ionique, puis une gravure chimique, on grave i'ensemble des couches 9, 8 et 7 de manière à mettre à nu la couche de confinement inférieure 2. Puis, comme représenté sur la figure 1G, on réalise sur cette couche de confinement inférieure 2, le dépôt d'un contact ohmique constitué par une couche d'or 11. Ainsi, on a pu réaliser un laser à ruban enterré sur un substrat semi-isolant tel que représenté en perspective sur la figure 2. Comme on le voit clairement sur les figures 1G ou 2, dans ce cas on diminue de manière importante la surface de contact entre la couche de confinement inférieure 2 et la couche de confinement supérieure 7. On diminue donc de façon notable l'homojonction P-N, à savoir la capacité parasite formée par cette homojonction. Cette homojonction peut présenter une dimension inférieure à 1µm.

Ainsi, en utilisant ce procédé, on a pu réaliser des lasers fonctionnant à plus de 10 GHz avec une puissance de 3 mW et pour une longueur de plus de 300 µm.

L'utilisation de diffusions permet d'intégrer facilement plusieurs dispositifs optoélectroniques du type à ruban enterré sur un même substrat semi-isolant. Un mode de réalisation de l'intégration de deux lasers à commandes séparées a été représenté à titre d'exemple sur la figure 3. On a réalisé deux rubans actifs 63, 63' recouverts chacun d'une zone de confinement supérieure 64, 64' en InP de type P de manière connue. Sur cette zone, et après avoir déposé et gravé une couche semi-isolante 65, on a réalisé deux diffusions 66', 66 sur toute la longueur du dispositif. Ces diffusions sont recouvertes de couches de contact 67, 67'. Pour éviter le contact de la métallisation 67 avec la métallisation 67', une couche de diélectrique 69 est déposée sur une partie du contact 67. Il est évident pour l'homme de l'art que le même procédé peut être utilisé pour intégrer d'autres dispositifs optoélectroniques.

## Revendications

1. Dispositif optoélectronique sur substrat semi-isolant du type comportant empilés l'un sur l'autre, au moins:
- un substrat en matériau semi-isolant (1),
- une couche de confinement inférieure (2) d'un premier type de conductivité,
- au moins une couche active (3) sous forme de ruban,
- une couche de confinement supérieure d'un deuxième type de conductivité, caractérisé en ce que la couche de confinement inférieure (2) recouvre un côté du substrat semi-isolant (1) en passant sous la couche active (3) et en s'arrêtant sensiblement au droit de cette couche active et en ce que la couche de confinement supérieure (4+7) recouvre l'autre côté du substrat semi-isolant (1) en passant sur la couche active (3) et en s'arrêtant sensiblement au droit de cette couche active (3).

2. Dispositif optoélectronique sur substrat semi-isolant du type comportant empilés l'un sur l'autre, au moins:
- un substrat en matériau semi-isolant (60),
- une couche de confinement inférieure (62) d'un premier type de conductivité,
- au moins une couche active dans laquelle sont gravés un premier (63) et un second (63') rubans,
- une couche de confinement supérieure (64,64') d'un deuxième type de conductivité, recouvrant chacun des deux rubans (63,63')
- une couche semi-isolante (65) dans laquelle deux zones diffusées (66,66') assurent le contact entre les deux rubans (63,63') et deux métallisations (67,67'),
caractérisé en ce que la couche de confinement inférieure (62) recouvre un côté du substrat semi-isolant (60) en passant sous les deux rubans (63,63') et en s'arrêtant sensiblement au droit d'un premier ruban (63) et en ce que la couche semi-isolante (65) recouvre l'autre côté du substrat semi-isolant (60) en passant sur les deux rubans (63,63') et en s'arrêtant sensiblement au droit du second ruban (63').

3. Dispositif selon l'une quelconque des revendications 1 à 2, caractérisé en ce que la couche de confinement inférieure (2) est réalisée en un matériau semi-conducteur dopé n et la couche de confinement supérieure (4+7) est réalisée en un matériau semiconducteur dopé p.

4. Dispositif selon la revendication 1, caractérisé en ce que la couche de confinement inférieure (2) est réalisée en un matériau semiconducteur dopé p et la couche de confinement supérieur (4+7) est réalisée en un matériau semiconducteur dopé n.

5. Dispositif selon la revendication 1, caractérisé en ce que la couche de confinement supérieure (4+7) est réalisée en un matériau semi-isolant dans lequel a été créée par diffusion une zone dopée p ou n suivant le dopage de la couche de confinement inférieure au-dessus de la couche active.

6. Dispositif selon la revendication 1, caractérisé en ce que la couche active (3) est en matériau semi-conducteur.

7. Dispositif selon l'une quelconque des revendications 3 à 6, caractérisé en ce que les matériaux semiconducteurs sont des composés des groupes III et V de la classification périodique des éléments.

8. Dispositif selon la revendication 7, caractérisé en ce que les couches de confinement optique inférieure (2) et supérieure (4+7) sont réalisées avec des composés binaires.

9. Dispositif selon la revendication 7, caractérisé en ce que la couche active (3) est réalisée avec des composés quaternaires ou ternaires.

10. Dispositif selon l'une quelconque des revendications 1 et 5, caractérisé en ce que le matériau semi-isolant est réalisé avec des composés binaires III et V de la classification périodique des éléments qui ont été dopés avec des impuretés telles que le fer et le cobalt.

11. Dispositif selon l'une quelconque des revendications 1 à 10, caractérisé en ce que la couche active (3) est formée d'une couche active recouverte d'une couche de guidage réalisée sous forme d'un réseau distribué.

12. Dispositif selon l'une quelconque des revendications 1 à 10, caractérisé en ce que la couche active (3) est constituée d'un empilement de couches de matériaux à gaps différents.

## Patentansprüche

1. Opto-elektronische Vorrichtung auf einem halbisolierenden Substrat, die in übereinanderliegenden Schichten mindestens enthält:
- ein Substrat (1) aus halbisolierendem Material,
- eine untere Einschließungsschicht (2) eines ersten Leitfähigkeitstyps,
- mindestens eine aktive Schicht (3) in Form eines Bandes,
- eine obere Einschließungsschicht eines zweiten Leitfähigkeitstyps, dadurch gekennzeichnet, daß die untere Einschließungsschicht (2) eine Seite des halbisolierenden Substrats (1) bedeckt und unter der aktiven Schicht (3) verläuft sowie im wesentlichen in Höhe dieser aktiven Schicht endet, und daß die obere Einschließungsschicht (4 und 7) die andere Seite des halbisolierenden Substrats (1) bedeckt, über der aktiven Schicht (3) verläuft und im wesentlichen in Höhe dieser aktiven Schicht (3) endet.

2. Opto-elektronische Vorrichtung auf einem halbisolierenden Substrat, die in übereinanderliegenden Schichten mindestens enthält:
- ein Substrat (60) aus halbisolierendem Material,
- eine untere Einschließungsschicht (62) eines ersten Leitfähigkeitstyps,
- mindestens eine aktive Schicht, in der ein erstes und ein zweites Band (63, 63') ausgeätzt sind,
- eine obere Einschließungsschicht (64, 64') eines zweiten Leitfähigkeitstyps, die jedes der beiden Bänder (63, 63') bedeckt,
- eine halbisolierende Schicht (65), in der zwei Diffusionszonen (66, 66') den Kontakt zwischen den beiden Bändern (63, 63') und zwei Metallbelägen (67, 67') herstellen, dadurch gekennzeichnet, daß die untere Einschließungsschicht (62) eine Seite des halbisolierenden Substrats (60) bedeckt, indem sie unter den beiden Bändern (63, 63') verläuft und im wesentlichen in Höhe eines ersten Bandes (63) endet, und daß die halbisolierende Schicht (65) die andere Seite des halbisolierenden Substrats (60) bedeckt, indem sie über den beiden Bändern (63, 63') verläuft und im wesentlichen in Höhe des zweiten Bands (63') endet.

3. Vorrichtung nach einem beliebigen der Ansprüche 1 bis 2, dadurch gekennzeichnet, daß die untere Einschließungsschicht (2) aus einem Halbleitermaterial mit n-Dotierung und die obere Einschließungsschicht (4 und 7) aus einem Halbleitermaterial mit p-Dotierung besteht.

4. Vorrichtung nach Anspruch 1, dadurch gekennzeichnet, daß die untere Einschließungsschicht (2) aus einem Halbleitermaterial mit p-Dotierung und die obere Einschließungsschicht (4 und 7) aus einem Halbleitermaterial mit n-Dotierung besteht.

5. Vorrichtung nach Anspruch 1, dadurch gekennzeichnet, daß die obere Einschließungsschicht (4 und 7) aus einem halbisolierenden Material besteht, in dem durch Diffusion eine Zone mit p- oder n-Dotierung je nach der Dotierung der unteren Einschließungsschicht oberhalb der aktiven Schicht erzeugt wird.

6. Vorrichtung nach Anspruch 1, dadurch gekennzeichnet, daß die aktive Schicht (3) aus einem Halbleitermaterial besteht.

7. Vorrichtung nach einem beliebigen der Ansprüche 3 bis 6, dadurch gekennzeichnet, daß die Halbleitermaterialien Stoffe aus den Gruppen III und V des Periodensystems der Elemente sind.

8. Vorrichtung nach Anspruch 7, dadurch gekennzeichnet, daß die untere optische Einschließungsschicht (2) und die obere optische Einschließungsschicht (4 und 7) aus binären Zusammensetzungen gebildet sind.

9. Vorrichtung nach Anspruch 7, dadurch gekennzeichnet, daß die aktive Schicht (3) aus quaternären oder ternären Zusammensetzungen gebildet ist.

10. Vorrichtung nach einem beliebigen der Ansprüche 1 bis 5, dadurch gekennzeichnet, daß das halbisolierende Material aus binären Zusammensetzungen der Gruppen III und V des Periodensystems der Elemente gebildet ist, die mit Verunreinigungen wie z.B. Eisen und Kobalt dotiert sind.

11. Vorrichtung nach einem beliebigen der Ansprüche 1 bis 10, dadurch gekennzeichnet, daß die aktive Schicht (3) aus einer aktiven Schicht besteht, die mit einer in Form eines verteilten Netzes ausgebildeten Führungsschicht bedeckt ist.

12. Vorrichtung nach einem beliebigen der Ansprüche 1 bis 10, dadurch gekennzeichnet, daß die aktive Schicht (3) aus der Übereinanderschichtung von Schichten aus Materialien mit unterschiedliche Gaps gebildet ist.

## Claims

1. Optoelectronic device on semi-insulating substrate, the type including, stacked one on top of the other, at least:
- a substrate (1) made of semi-insulating material,
- a lower confinement layer (2) of a first conductivity type,
- at least one active layer (3) in the form of a stripe,
- an upper confinement layer of a second conductivity type,
characterised in that the lower confinement layer (2) covers one side of the semi-insulating substrate (1), passing beneath the active layer (3) and stopping substantially in line with this active layer, and in that the upper confinement layer (4+7) covers the other side of the semi-insulating substrate (1), passing over the active layer (3) and stopping substantially in line with this active layer (3).

2. Optoelectronic device on semi-insulating substrate, of the type including, stacked one on top of the other, at least:
- a substrate (60) made of semi-insulating material,
- a lower confinement layer (62) of a first conductivity type,
- at least one active layer in which a first stripe (63) and a second stripe (63') are etched,
- an upper confinement layer (64, 64') of a second conductivity type covering each of the two stripes (63, 63'),
- a semi-insulating layer (65) in which two diffused zones (66, 66') provide the contact between the two stripes (63, 63') and two metallisations (67, 67'),
characterised in that the lower confinement layer (62) covers one side of the semi-insulating substrate (60), passing beneath the two stripes (63, 63') and stopping substantially in line with a first stripe (63) and in that the semi-insulating layer (65) covers the other side of the semi-insulating substrate (60), passing over the two stripes (63, 63') and stopping substantially in line with the second stripe (63').

3. Device according to either of Claims 1 and 2, characterised in that the lower confinement layer (2) is produced from a n-doped semiconductor material and the upper confinement layer (4+7) is produced from a p-doped semiconductor material.

4. Device according to Claim 1, characterised in that the lower confinement layer (2) is produced from a p-doped semiconductor material and the upper confinement layer (4+7) is produced from a n-doped semiconductor material.

5. Device according to Claim 1, characterised in that the upper confinement layer (4+7) is produced from a semi-insulating material in which a p- or n-doped zone is created by diffusion, depending on the doping of the lower confinement layer above the active layer.

6. Device according to Claim 1, characterised in that the active layer (3) is made of semiconductor material.

7. Device according to any one of Claims 3 to 6, characterised in that the semiconductor materials are compounds of Groups III and V of the periodic table of the elements.

8. Device according to Claim 7, characterised in that the lower optical confinement layer (2) and upper optical confinement layer (4+7) are produced with binary compounds.

9. Device according to Claim 7, characterised in that the active layer (3) is produced with quaternary or ternary compounds.

10. Device according to either of Claims 1 and 5, characterised in that the semi-insulating material is produced with binary compounds of the groups III and V of the periodic table of the elements which have been doped with impurities such as iron and cobalt.

11. Device according to any one of Claims 1 to 10, characterised in that the active layer (3) is formed from an active layer covered by a guide layer produced in the form of a distributed pattern.

12. Device according to any one of Claims 1 to 10, characterised in that the active layer (3) consists of a stack of layers of materials having different gaps.
